Europäisches Patentamt

European Patent Office

Office européen des brevets

(11) Veröffentlichungsnummer: **0 254 103 B1**

(12) **EUROPÄISCHE PATENTSCHRIFT**

(45) Veröffentlichungstag der Patentschrift: **18.03.92**

(51) Int. Cl.5: **B01D 69/06**, B01D 39/20, G03F 7/00, G03C 5/00

(21) Anmeldenummer: **87109589.9**

(22) Anmeldetag: **03.07.87**

(54) **Mikrofilterfolie aus anorganischem Material, insbesondere Metall, und Verfahren zu seiner Herstellung.**

(30) Priorität: **23.07.86 CH 2945/86**

(43) Veröffentlichungstag der Anmeldung:
**27.01.88 Patentblatt 88/04**

(45) Bekanntmachung des Hinweises auf die Patenterteilung:
**18.03.92 Patentblatt 92/12**

(84) Benannte Vertragsstaaten:
**AT BE DE FR GB IT NL SE**

(56) Entgegenhaltungen:
**US-A- 3 291 871**
**US-A- 4 402 571**
**US-A- 4 575 406**

(73) Patentinhaber: **GEBRÜDER SULZER AKTIENGE-SELLSCHAFT**
**Zürcherstrasse 9**
**CH-8401 Winterthur(CH)**

(72) Erfinder: **Ehrsam, Christian, Dr.**
**Obermühlestrasse 2**
**CH-8400 Winterthur(CH)**
Erfinder: **Rüegg, Thomas, Dr.**
**Oberwilerstrasse 30**
**CH-8547 Gachnang(CH)**

## Beschreibung

Die Erfindung bezieht sich auf eine Mikrofilterfolie aus anorganischem Material, insbesondere Metall, gemäss Oberbegriff von Anspruch I und ein Verfahren zur Herstellung derselben.

Eine derartige Mikrofilterfolie ist ein sogenanntes Oberflächen- oder Siebfilter, das sich als Filtermedium für Querstromfiltration eignet. Da bei diesem Verfahren sich kein Filterkuchen auf dem Filtermedium absetzt, ist eine kontinuierliche Filtration möglich. Die Poren dieser Mikrofilterfolie können kleiner als Bakterien, deren Zellgrössen mindestens 0,2 μm beträgt, ausgebildet werden. Daher ist eine kontinuierliche Entkeimungsfiltration möglich.

Die Entkeimungsfiltration ist ein physikalisches Verfahren, das die Entfernung von Bakterien und anderen Mikroorganismen aus Flüssigkeiten und Gasen ermöglicht.

Einsatzgebiete sind z.B. Pharma-, Kosmetik- , Getränkeindustrie und Biotechnologie.

Ausser für die Entkeimungsfiltration lässt sich ein derartiges Mikrofilter auch für die Feinklärung und für die Hochreinigung von Flüssigkeiten und Gasen - beispielsweise in der Mikroelektronik - verwenden.

Aus der US-PS 4 575 406 sind metallische Mikrofilterfolien bekannt. Hierbei sollen die metallischen Mikrofilterfolien in einem Verfahren hergestellt werden, bei welchem eine lichtempfindliche Lackschicht auf ein Substrat mit ebener Oberfläche aufgetragen wird. Nach Belichtung mit einem Interferenzmuster, das mittels monochromatischen und kohärenten Lichtwellen eines Lasers erzeugt wird, und anschliessender Entwicklung entsteht auf der lichtempfindlichen Lackschicht ein Relief.

Dieses Relief weist gitterartig verteilte Vertiefungen in der Lackschicht auf. In einem anschliessenden Verfahrensschritt wird die Oberfläche des Reliefs mit einer elektrisch leitenden Schicht bedeckt, wobei die Vertiefungen entweder unbedeckt bleiben sollen oder im anderen Fall, wenn sie ebenfalls bedeckt worden sind, anschliessend mit einem Isolationsmaterial aufgefüllt werden sollen.

Anschliessend wird die Filterfolie in einem galvanoplastischen Verfahren erzeugt, wozu das Substrat in ein galvanisches Bad eingetaucht wird. Oberhalb der Vertiefungen bilden sich dann die Poren in der elektrolytisch erzeugten Schicht aus. Da diese Schicht nicht nur in die Höhe wächst, sondern oberhalb der Vertiefungen auch seitlich, weisen die entstehenden Poren Einschnürungen auf, d.h. ihr kleinster Durchmesser befindet sich innerhalb der Filterschicht. Hierdurch sind während des Betriebs Verstopfungen der Poren unvermeidlich, da sich auszufiltrierende Partikelchen in den Poren absetzen können und ähnlich wie Ventilkörper auf einem Ventilsitz den Durchfluss des Filtrats unterbinden.

Ein weiterer Nachteil bei der Herstellung der bekannten Mikofilter besteht in der Verschmutzungsgefahr, welche bei elektrolytischen verfahren durch Verunreinigungen des galvanischen Bades nur mit grossem Aufwand vermeidbar ist. Auch bei der Präparation des Lackreliefs, insbesondere wenn die Vertiefungen mit Isolationsmaterial aufgefüllt werden, besteht die Gefahr, dass sich Verunreinigungen auf der leitenden Schicht des Reliefs absetzen. So können Poren ungleichmässiger Grösse entstehen, oder es kann sich sogar auf Flecken, die zwei oder mehr Poren umfassen, überhaupt keine Metallschicht aufbauen.

Der Erfindung liegt demgegenüber die Aufgabe zugrunde, eine Mikrofilterfolie aus anorganischem Material, insbesondere Metall, zu verwirklichen, die eine äusserst gleichmässige Verteilung der Poren aufweist, wobei die Poren weitgehend gleiche Grösse haben, und wobei eine Verstopfungsgefahr während des Betriebes nahezu vermieden wird.

Diese Aufgabe wird für eine Mikrofilterfolie mit den Merkmalen des Kennzeichens von Anspruch 1 gelöst.

Das Verfahren zur Herstellung eines erfindungsgemässen Filters ist durch die im Kennzeichen des Anspruchs 4 angegebenen Massnahmen gekennzeichnet.

Vorteilhafte Ausführungsformen bzw. Weiterbildungen der Erfindung sind in den Kennzeichen der Ansprüche 2, 3 und 5 bis 11 angegeben.

Die Mikrofilterfolie weist einen asymmetrischen Aufbau auf, d.h. das fertiggestellte Filter ist nur in einer Richtung funktionsfähig.

Die Folie kann aus einem Metall, wie z.B. Gold, Nickel oder Titan, aus einer Legierung, beispielsweise aus Gold und Palladium oder auch aus einem anderen anorganischen Material, wie z.B. aus Titannitrid bestehen.

Die Erfindung wird im folgenden anhand von in der Zeichnung dargestellten Ausführungsbeispielen erläutert.

Die Fig. la und I b zeigen in Draufsicht zwei in einer lichtempfindlichen Lackschicht erzeugte Interferenzmuster, die jeweils mittels zwei Belichtungen hergestellt worden sind.

In den Fig. lc und ld sind schematisch Teillängsschnitte durch eine Mikrofilterfolie auf einem Substrat in verschiedenen Herstellungsstadien dargestellt,

während Fig. le in perspektivischer Darstellung einen Ausschnitt einer fertiggestellten Mikrofilterfolie zeigt.

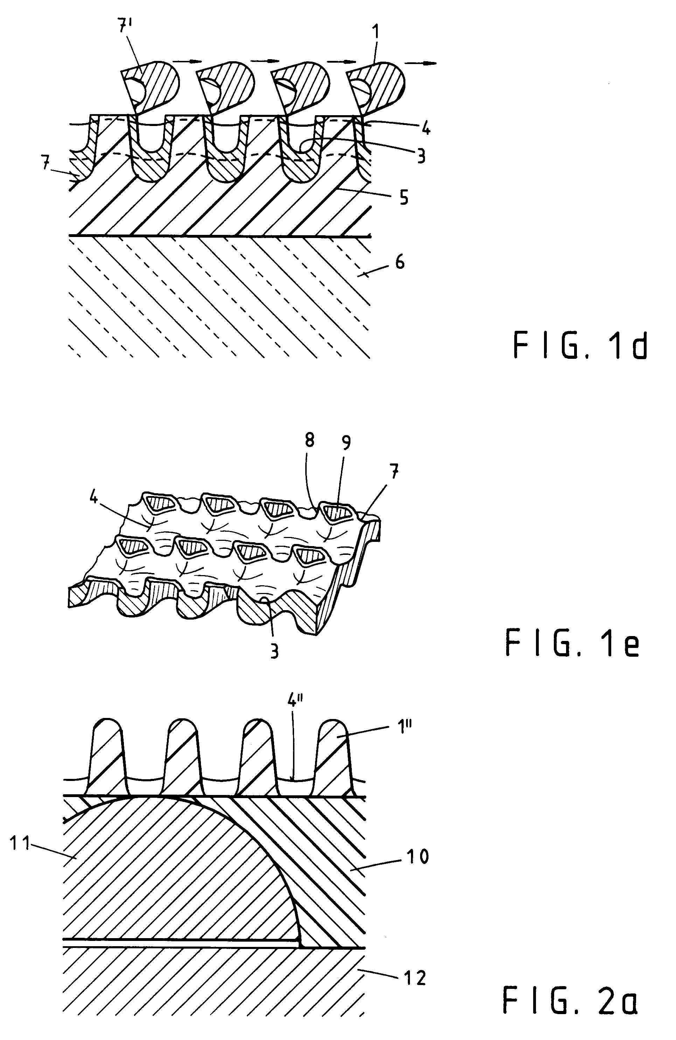

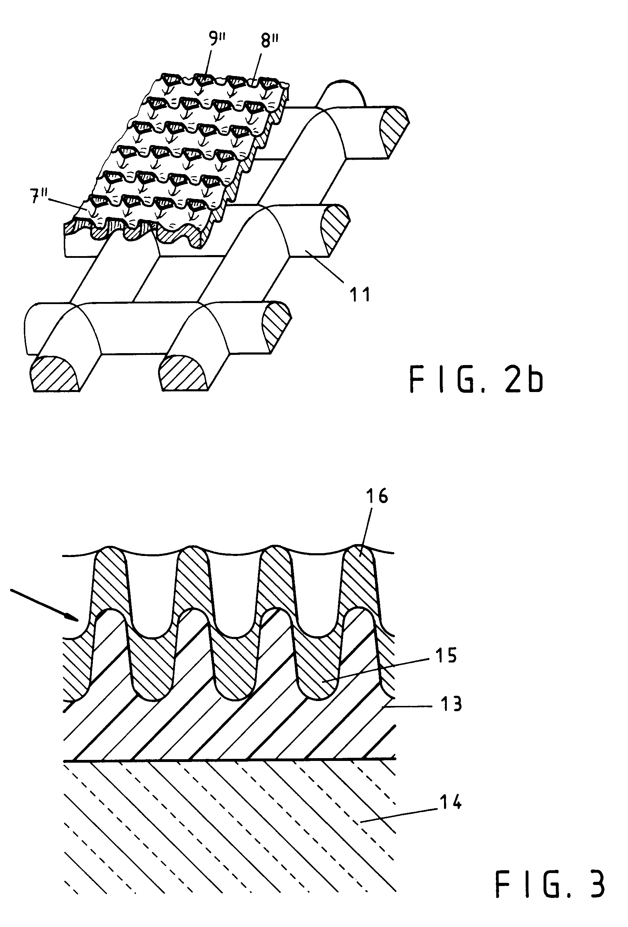

Fig. 2a zeigt in einem Teillängsschnitt eine auf einer Stützstruktur reliefartig verformte, lichtempfindliche Lackschicht,

während in Fig. 2b in perspektivischer Darstellungsweise ein Teilausschnitt der fertiggestellten Mikrofilterfolie auf der Stützstruktur gezeigt ist.

In Fig. 3 ist in einem Teillängsschnitt eine abgewandelte Ausführungsform einer Mikrofilterfolie nach der Beschichtung dargestellt.

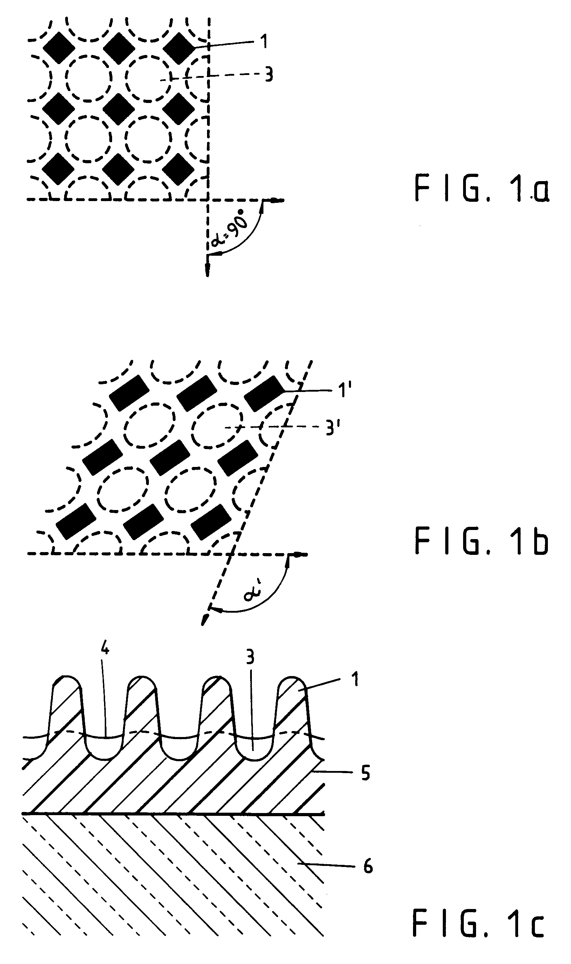

Die in den Fig. 1a und 1b dargestellten Interferenzmuster sind mittels einer Lichtquelle mit monochromatischem Licht erzeugt worden. Hierbei werden mittels einer speziellen Optik zwei kohärente Strahlenbündel gleicher Intensität überlagert und auf eine lichtempfindliche Lackschicht projiziert. Es ist bekannt, als Lichtquelle Laserstrahlen zu verwenden, die beide Bedingungen hinsichtlich Kohärenz und Monochromatie erfüllen.

In beiden Ausführungsbeispielen ergeben sich Reliefstrukturen mit aufrechtstehenden Zäpfchen 1 und 1' und dazwischenliegenden Mulden 3 und 3'. Die Interferenzmuster werden durch zwei kreuzweise sich überlagernde Belichtungen mit Liniengittern hergestellt, wobei im Falle der Fig. 1a die zweite Gitterorientierung gegenüber der ersten um einen Winkel $\alpha$ von 90° gedreht ist. Hierbei werden nach der Entwicklung Zäpfchen mit einem quadratischen Querschnitt mit abgerundeten Ecken erzeugt.

Das in Fig. 1b dargestellte Interferenzmuster ist auf die gleiche Art und Weise wie Fig. 1a erzeugt worden, bis darauf, dass die beiden Gitterorientierungen einen Winkel $\alpha'$ einschliessen, der grösser als 90° ist. Hierdurch entstehen Zäpfchen mit länglichen Querschnitten.

Eine andere Möglichkeit besteht darin, Interferenzmuster in einer lichtempfindlichen Lackschicht mittels drei monochromatischen und kohärenten Strahlen zu erzeugen. In diesem Fall ist nur eine Belichtung zur Herstellung eines Punktgitters erforderlich.

Die Fig. 1c bis 1e zeigen einzelne Herstellungsstadien einer Mikrofilterfolie, wobei von einem Interferenzmuster gemäss Fig. 1a ausgegangen werden soll.

Gemäss Fig. 1c ist eine lichtempfindliche Lackschicht 5 auf ein Substrat, im Beispiel einer Glasplatte 6 aufgebracht. Die Schichtdicke beträgt beispielsweise das Zehnfache eines Porendurchmessers. Obwohl die Erfindung auch den Fall umfassen soll, bei dem transparentes Glas als Substrat verwendet wird, ist es von besonderem Vorteil, Filterglas zu benutzen oder auf der Rückseite des Glas-Substrates eine lichtabsorbierende Schicht aufzubringen. Auf diese Weise wird eine Reflektion der einfallenden Strahlen bei der Erzeugung des Interferenzmusters vermieden, was zu einer Variation der Belichtungsintensität und damit Abweichung des gewünschten Reliefs führen könnte.

Fig. 1c zeigt das nach der Belichtung und der Entwicklung erzeugte Relief der Lackschicht, wobei die erwünschte Formgebung durch die Länge und Intensität des Belichtens und anschliessenden Entwickelns bestimmt ist. Dieses Relief weist schlanke, sich nach oben verjüngende Zäpfchen 1 mit dazwischenliegenden Mulden 3 und Sätteln 4 auf. Die Zäpfchenhöhe beträgt beispielsweise das Zwei- bis Dreifache ihrer mittleren Durchmesser.

In einem nichtdargestellten Verfahrensschritt wird das Relief mit einer, aus einem anorganischen Material bestehenden Haut durch Kathodenzerstäubung oder Aufdampfen im Vakuum überzogen. Sodann werden die mit der Haut 7, 7', die beispielsweise aus Metall besteht, überzogenen Zäpfchen abgeknickt, wie dieses in Fig. 1d dargestellt ist, sodann entfernt.

Da der Lack spröde ist, brechen die Zäpfchen leicht. So können sie beispielsweise durch Ueberstreichen mit elastischen Fasern, die z.B. auf einer rotierenden Walze angebracht sind, abgeknickt werden, wobei jeder Punkt mindestens einmal überstrichen wird. Beim Abknicken bilden sich keine glatten, sondern unebene Randpartien aus, was ein Festsetzen von Partikelchen beim Filtrieren erschwert.

Es ist auch möglich, beispielsweise mit Hilfe von Elektropolieren das auf den Spitzen der Zäpfchen aufgebrachte Metall abzutragen.

Fig. 1e zeigt in perspektivischer Darstellungsweise einen Teilausschnitt der fertiggestellten Mikrofilterfolie, die nach Entfernung des lichtempfindlichen Lacks nur noch aus der Haut 7 besteht.

Auf den Scheiteln der kegelstumpfartigen Erhebungen 8 befinden sich die Poren 9. Fig. 1e zeigt auf der linken Seite einen Schnitt durch die Poren, woraus ersichtlich ist, dass sich der kleinste Querschnitt der Poren auf der Oberfläche der Folie befindet und sich der Porenquerschnitt in Richtung zur Rückseite hin vergrössert. Auf der rechten Seite der Fig. 1e ist ein Schnitt durch Mulden 3 gezeigt.

Fig. 2a zeigt in einem Längsschnitt einen Ausschnitt eines, aus lichtempfindlichem Lack gebildeten Reliefs mit Zäpfchen 1" und Sättel 4" entsprechend der Fig. 1c. Abweichend hiervon gehen die muldenartigen Vertiefungen bis zur Oberfläche des Substrates 10. Ausserdem zeigt auch das Substrat 10 eine andere Ausführungsform als die Fig. 1c bis 1d. Im vorliegenden Fall besteht es aus einer siebartigen Stützstruktur mit Stegen 11, die beispielsweise galvanoplastisch hergestellt ist und die auf einer ebenen Platte 12 befestigt ist. Die Zwischenräume des Siebes sind mit einem lichtabsorbierenden Material ausgefüllt. An den Stellen, an denen die Stege 11 des Siebes vom lichtempfindlichen Lack freigelegt werden, ergeben sich feste Verbindungen zwischen der Mikrofilterfolie und dem Sieb, das so zur Stützstruktur des Filters wird (vergl. Fig. 2b).

Fig. 3 zeigt in einem Längsschnitt einen Ausschnitt einer Mikrofilterfolie, die nach einem gegenüber den Fig. 1c bis le abgewandelten Verfahren hergestellt ist. Die Erzeugung des Interferenzmusters in der lichtempfindlichen Lackschicht l3, die auf einer ebenen Glasplatte l4 aufgebracht ist, erfolgt in der gleichen Weise wie beim ersten Ausführungsbeispiel. Jedoch wird im vorliegenden Fall bei kürzeren Belichtungszeiten das Relief mit lochartigen Vertiefungen l5 ausgebildet. Die auf das Relief aufgebrachte Haut l6 aus einem anorganischen Material wird dadurch perforiert, d.h. die Poren geöffnet, dass die gesamte Haut l6 in Pfeilrichtung abgezogen wird, wobei das in den lochartigen Vertiefungen l5 abgeschiedene anorganische Material durch Abreissen in diesen Vertiefungen verbleibt.

## Patentansprüche

1. Mikrofilterfolie aus anorganischem Material, insbesondere Metall, mit offenen Poren, die eine rasterartige Anordnung aufweisen, wobei die Mikrofilterfolie einen asymmetrischen Aufbau besitzt, dadurch gekennzeichnet, dass die filtrierende Oberfläche ein Relief mit zäpfchenförmigen Erhebungen aufweist, auf deren Scheiteln sich die Porenöffnungen befinden, und dass die Querschnitte der Porenkanäle sich in Strömungsrichtung des Filtrats vergrössern.

2. Mikrofilterfolie nach Anspruch 1, dadurch gekennzeichnet, dass die Poren alle nahezu gleich gross sind und einen mittleren Durchmesser im Bereich von 0,1 bis 1 $\mu$m aufweisen.

3. Mikrofilterfolie nach Anspruch 1, dadurch gekennzeichnet, dass die Porenöffnungen unebene Ränder aufweisen.

4. Verfahren zur Herstellung einer Mikrofilterfolie nach Anspruch 1, durch Belichten eines lichtempfindlichen Lacks, der auf einer ebenen Fläche aufgetragen ist, mit einem Interferenzmuster, das durch zwei kreuzweise sich überlagernde Belichtungen mit Liniengittern hergestellt wird, und durch Entwickeln des Lacks zu einem rasterartigen Relief, dadurch gekennzeichnet, dass auf der mit dem Relief versehenen Lackschicht eine diese überziehende Haut aus anorganischem Material erzeugt wird, dass sodann diese Haut durch mechanische Einwirkung an Stellen, die durch die Reliefstruktur ausgezeichnet sind, perforiert wird und dass anschliessend der Lack von der Mikrofilterfolie entfernt wird.

5. Verfahren nach Anspruch 4, dadurch gekennzeichnet, dass die lichtempfindliche Schicht mit einem Relief von aufrechtstehenden Zäpfchen, Mulden und Sätteln versehen wird, und dass die auf das Relief aufgebrachte Haut aus anorganischem Material durch Abbrechen der beschichteten Zäpfchen perforiert wird.

6. Verfahren nach Anspruch 4, dadurch gekennzeichnet, dass die lichtempfindliche Schicht mit einem Relief von lochartigen Vertiefungen versehen wird, und dass die auf das Relief aufgebrachte Haut aus anorganischem Material dadurch perforiert wird, dass die gesamte Haut vom Relief abgezogen wird, wobei das in den lochartigen Vertiefungen abgeschiedene anorganische Material durch Abreissen in diesen Vertiefungen zurückbleibt.

7. Verfahren nach einem der Ansprüche 4 bis 6, dadurch gekennzeichnet, dass die Haut aus anorganischem Material durch Kathodenzerstäubung erzeugt wird.

8. Verfahren nach einem der Ansprüche 4 bis 7, dadurch gekennzeichnet, dass der lichtempfindliche Lack auf eine Glasplatte aufgebracht wird.

9. Verfahren nach Anspruch 8 mit einer Glasplatte, die höchstens 3 % des eingestrahlten Lichts reflektiert.

10. Verfahren nach einem der Ansprüche 4 bis 9, dadurch gekennzeichnet, dass bei den durch die zwei kreuzweise sich überlagernden Belichtungen die zweite Gitterorientierung gegenüber der ersten um einen zumindest angenähert rechten Winkel gedreht wird.

11. Verfahren nach Anspruch 5, dadurch gekennzeichnet, dass bei den durch die zwei kreuzweise sich überlagernden Belichtungen die zweite Gitterorientierung gegenüber der ersten um einen Winkel gedreht wird, durch den sich Zäpfchen mit länglichen Querschnitten ergeben.

## Claims

1. A microfilter foil of inorganic material, more particularly metal, having open pores having a raster-like arrangement, the microfilter foil having an asymmetrical structure, characterised in that the filtering surface comprises a relief with peg-shaped projections, on the apices of which the pore openings are situated and in that the cross-sections of the pore ducts increase in size in the direction of flow of the filtrate.

2. A microfilter foil according to claim 1, characterised in that the pores are all substantially of the same size and have an average diameter in the range of from 0.1 to 1 $\mu$m.

3. A microfilter foil according to claim 1, characterised in that the pore openings have uneven edges.

4. A method of making a microfilter foil according to claim 1, by exposing a photo-sensitive varnish applied to a flat surface, with an interference pattern made by two exposures with line gratings, said exposures being superposed cross-wise, and by developing the varnish to form a relief in the form of a raster, characterised in that a skin of inorganic material which covers the layer of varnish provided with the relief is produced on said layer, in that the said skin is then perforated by mechanical action at places distinguished by the relief structure and in that the varnish is then removed from the microfilter foil.

5. A method according to claim 4, characterised in that the photosensitive layer is provided with a relief of upright pegs, troughs and saddles, and in that the skin of inorganic material applied to the relief is perforated by breaking off the coated pegs.

6. A method according to claim 4, characterised in that the photosensitive layer is provided with a relief of recesses in the form of holes and in that the skin of inorganic material applied to the relief is perforated by withdrawing the entire skin from the relief, the inorganic material deposited in the recesses in the form of holes remaining therein by breaking off.

7. A method according to any one of claims 4 to 6, characterised in that the skin of inorganic material is produced by cathode sputter.

8. A method according to any one of claims 4 to 7, characterised in that the photosensitive varnish is applied to a glass plate.

9. A method according to claim 8 with a glass plate reflecting not more than 3% of the incident light.

10. A method according to any one of claims 4 to 9, characterised in that during the two croswise superposed exposures the second grating orientation is turned through an at least approximate right angle with respect to the first orientation.

11. A method according to claim 5, characterised in that during the two crosswise superposed exposures the second grating orientation is turned with respect to the first through an angle which results in pegs of elongate cross-sections.

**Revendications**

1. Feuille de filtre microporeux en matériau inorganique, notamment en métal, présentant des pores ouverts disposés de manière à former une trame, la feuille de filtre microporeux présentant une construction asymétrique, caractérisée en ce que la surface filtrante présente une structure avec des reliefs en forme de plots au sommet desquels se trouvent les ouvertures des pores, et en ce que les sections transversales des canaux des pores augmentent dans le sens de l'écoulement du filtrat.

2. Feuille de filtre microporeux selon la revendication 1 caractérisée en ce que les pores sont à peu près tous de même grosseur et présentent un diamètre moyen de l'ordre de 0,1 à l $\mu$m.

3. Feuille de filtre microporeux selon la revendication 1, caractérisée en ce que les ouvertures des pores présentent des bords non plans.

4. Procédé de fabrication d'une feuille de filtre microporeux selon la revendication 1, par exposition à la lumière d'un vernis photosensible qui est supporté par une surface plane, avec un modèle d'interférence réalisé par deux expositions se superposant en croix avec des grilles de lignes et par développement du vernis pour donner un relief tramé, caractérisé en ce qu'il est produit sur la couche de vernis pourvue du relief, une pellicule en matériau inorganique recouvrant celle-ci, en ce qu'ensuite cette pellicule est perforée mécaniquement en des points qui sont désignés par la structure en relief et en ce qu'ensuite le vernis est éliminé de la feuille de filtre microporeux.

5. Procédé selon la revendication 4, caractérisé en ce que la couche photosensible est pourvue d'un relief fait de plots verticaux, de creux et de bosses, et en ce que la pellicule appliquée sur le relief, en matériau inorganique, est perforée par rupture des plots recouverts.

6. Procédé selon la revendication 4, caractérisé en ce que la couche photosensible est pourvue d'un relief fait de creux semblables à des trous et en ce que la pellicule appliquée sur le relief, en matériau inorganique, est perforée par le fait que la totalité de la pellicule est retirée du relief, le matériau inorganique déposé dans les creux semblables à des trous restant dans ces creux après arrachage.

7. Procédé selon l'une des revendications 4 à 6, caractérisé en ce que la pellicule en matériau inorganique est produite par pulvérisation cathodique.

8. Procédé selon l'une des revendications 4 à 7, caractérisé en ce que le vernis photosensible est appliqué sur une plaque de verre.

9. Procédé selon la revendication 8 avec une plaque de verre qui réfléchit au maximum 3 % de la lumière émise.

10. Procédé selon l'une des revendications 4 à 9, caractérisé en ce que sur les deux expositions se superposant en croix, la deuxième orientation de grille est tournée, par rapport à la première, d'un angle au moins à peu près droit.

11. Procédé selon la revendication 5, caractérisé en ce que sur les deux expositions se superposant en croix, la deuxième orientation de grille est tournée, par rapport à la première, d'un angle donnant des plots de section transversale allongée.

FIG. 1a

FIG. 1b

FIG. 1c

F I G. 1d

F I G. 1e

F I G. 2a

FIG. 2b

FIG. 3